# EUROPEAN PATENT SPECIFICATION

(11) **EP 4 321 926 B1**
(45) Date of publication and mention of the grant of the patent: **18.09.2024**
(21) Application number: 22189469.4
(22) Date of filing: 09.08.2022
(51) Int. Cl.: G02F 1/1335, F21V 8/00

(54) **COLOR CONVERSION FILM WITH ALD SEALED EDGES**
FARBUMWANDLUNGSFILM MIT ALD-VERSIEGELTEN KANTEN
FILM DE CONVERSION DE COULEUR AVEC DES BORDS ALD SCELLÉS

(43) Date of publication of application: 14.02.2024
(73) Proprietor: Avantama AG, 8712 Stäfa (CH)
(72) Inventor: LÜCHINGER, Norman, 8706 Meilen (CH)
(74) Representative: E. Blum & Co. AG

(56) References cited:
- EP-A1- 3 936 585
- US-A1- 2019 154 901
- US-A1- 2020 209 463
- US-A1- 2020 251 529
- US-B1- 9 470 399
- FANG FAN ET AL: "Atomic Layer Deposition Assisted Encapsulation of Quantum Dot Luminescent Microspheres toward Display Applications", ADVANCED OPTICAL MATERIALS, vol. 8, no. 12, 1 June 2020 (2020-06-01), DE, pages 1902118, XP093011450, ISSN: 2195-1071, Retrieved from the Internet <URL:https://onlinelibrary.wiley.com/doi/full-xml/10.1002/adom.201902118> [retrieved on 20230103], DOI: 10.1002/adom.201902118

## Description

### Technical Field

The present invention relates to the field of color conversion films which are suited for use in display backlight components and light emitting devices. The invention particularly provides color conversion films with edge-sealing, thereby imparting an improved stability of such films. Further, the invention relates to new manufacturing processes to obtain edge-sealed color conversion films.

### Background art

Color conversion films are known and widely used in industry, such as in LCD backlights. Such films comprise green and/or red color conversion materials which emit green and respectively red light upon excitation by blue light. Such films are produced on roll-to-roll coating equipment resulting in a color conversion film roll. Finally rectangular sheets with about the size of the corresponding LCD display are cut out from the color conversion film roll by e.g. die-cutting or laser cutting. The resulting cut edges of the rectangular shaped color conversion films leave the color conversion materials in the QD film exposed to air. The cut edges of such color conversion films contain defects such as fine cutting cracks or other irregularities.

Color conversion films are known to be sensitive towards air and humidity. Typically, the major surfaces of such films are therefore covered with protective layers. In this context, Nehm et al (ACS Appl. Mater. Interfaces 2015, 7, 22121-22127) discuss ultrathin ALD-deposited AlOx films. The authors observed these AlOx films being unstable if exposed directly to ambient relative humidity and rapidly loose their protective properties. To resolve this drawback, an additional coating, preferably a glued-on PET foil provides reliable WVTR down to 2*10⁻⁵ g (H₂0) m⁻²d⁻¹ at 38°, 90 % r.h. It is apparent that this approach may be suitable to the major surface of a film, but not to the edges of such film.

Edge ingress is a known problem in industry and discussed e.g. in Nelson et al (TechConnect Breif 2015, ISBN 978-1-4987-4727-1, p.282 - 285). Briefly, the color conversion materials (especially quantum dots and perovskite crystals) degrade at the edges of such films due to humidity and/or oxygen diffusing into the film starting from the edges. This causes so-called edge ingress, which is the distance from the edge towards the center of the film over which the green and/or red color conversion materials are degraded and either non-luminescent anymore or strongly reduced in luminescence. Nelson et al acknowledge the problem of edge ingress without providing any proposal how to address it.

Kim et al (US2020/0209463) disclose light guide plates and display devices including the same. In this context, sealed colour conversion films are depicted. The sealing disclosed in this document is of non-uniform thickness and does not allow appropriate control of edge ingress.

Further, Skipor et al (US9470399) disclose light emitting polymer films, displays containing the same and their manufacturing. Its side surfaces are protected with barrier layers. It is suggested to form such barriers using transfer molding.

Still further, Luechinger et al (EP3936585) discloses self-supporting films and light emitting devices. The document is silent on sealing of edges.

Still further, Chu (US2020/0251529) discloses display devices where edge portions are sealed by thermal curing using laser technology.

Still further, Lee et al (US2019/0154901) discloses light guiding panels comprising a passivation layer on the edges of a wavelength conversion layer and suggests using CVD for obtaining the same.

Finally, Fang et al (Adv. Optical Mater., 2020, 8, 1902118) discuss the encapsulating of quantum dots a combined sol-gel and ALD process to obtain a multi-layer coating of SiO2 and Al2O3 on said QDs.

### Disclosure of the Invention

The present invention aims to overcome one or more of the disadvantages of the prior art. In particular, the present invention addresses the need for color conversion films having improved stability over its whole surface area. This is achieved by avoiding, or at least reducing, edge ingress of color conversion films.

Specifically, the objectives are achieved by providing edge-sealed color conversion films as defined in claim 1 and by providing manufacturing methods as described in claim 9. Further aspects of the invention are disclosed in the specification and independent claims, preferred embodiments are disclosed in the specification and the dependent claims.

The present invention will be described in more detail below. It is understood that the various embodiments, preferences and ranges as provided / disclosed in this specification may be combined at will. Further, depending of the specific embodiment, selected definitions, embodiments or ranges may not apply.

Unless otherwise stated, the following **definitions** shall apply in this specification:
The terms "a", "an" "the" and similar terms used in the context of the present invention are to be construed to cover both the singular and plural unless otherwise indicated herein or clearly contradicted by the context. The term "containing" shall include all, "comprising", "essentially consisting of" and "consisting of". Percentages are given as weight-%, unless otherwise indicated herein or clearly contradicted by the context. "Independently" means that one substituent / ion may be selected from one of the named substituents / ions or may be a combination of more than one of the above.

A **"film"** is a thin structure, comprising one or more layers ("laminate) and comprising two major surfaces separated by edges. **Top film area:** The top film area describes the upper surface of the color conversion film. **Bottom film area:** The bottom film area describes the surface of the color conversion film at the bottom opposite to the top film area. Top and bottom film area are also collectively referred to as **"major surface areas". Edge areas:** The first, second, third and fourth edge area describe the area of each of the four edges of the rectangular-shaped color conversion sheet. For disc-shaped films, a single edge separates top and bottom film area.

The term **"color conversion material"** is known in the field and in the context of the present invention relates to materials which upon excitation by blue light emit light in the visible range. In the context of the present invention it is preferred that color conversion materials emit red or green light. Color conversion materials can be organic (polymers or small organic molecules) or inorganic. Inorganic color conversion materials preferably are selected from the list of luminescent crystals, quantum dots, perovskite crystals, or micron-sized phosphors, most preferably perovskite crystals and quantum dots.

The term **"luminescent crystal"** (LC) is known in the field and in the context of the present invention relates to crystals of 2-100 nm, made of semiconductor materials. The term comprises quantum dots, typically in the range of 2 - 10 nm and nanocrystals, typically in the range of 10 - 100 nm.

LCs show, as the term indicates, luminescence. In the context of the present invention the term luminescent crystal includes both, single crystals and polycrystalline particles. In the latter case, one particle may be composed of several crystal domains (grains), connected by crystalline or amorphous phase boundaries. A luminescent crystal is a semiconducting material which exhibits a direct bandgap (typically in the range 1.1 - 3.8 eV, more typically 1.4 - 3.5 eV, even more typically 1.7 - 3.2 eV). Upon illumination with electromagnetic radiation equal or higher than the bandgap, the valence band electron is excited to the conduction band leaving an electron hole in the valence band. The formed exciton (electron-electron hole pair) then radiatively recombines in the form of photoluminescence, with maximum intensity centered around the LC bandgap value and exhibiting photoluminescence quantum yield of at least 1 %. In contact with external electron and electron hole sources LC could exhibit electroluminescence.

The term **"quantum dot"** (QD) is known and particularly relates to semiconductor nanocrystals, which have a diameter typically between 2 - 10 nm. In this range, the physical radius of the QD is smaller than the bulk ex-citation Bohr radius, causing quantum confinement effect to predominate. As a result, the electronic states of the QD, and therefore the bandgap, are a function of the QD composition and physical size, i.e. the color of absorption/emission is linked with the QD size. The optical quality of the QDs sample is directly linked with their homogeneity (more monodisperse QDs will have smaller FWHM of the emission). When QD reach size bigger than the Bohr radius the quantum confinement effect is hindered and the sample may not be luminescent anymore as nonradiative pathways for exciton recombination may become dominant. Thus, QDs are a specific sub-group of nanocrystals, defined in particular by its size and size distribution. Typical quantum dot compositions comprise Cadmium or Indium, for example in the form of Cadmium Selenide (CdSe) or Indium Phosphide (InP).

The term **"core-shell quantum dots"** is known and particularly relates to quantum dots typically containing an Indium comprising or Cadmium comprising core, typically having a CdSe core or InP core having an additional shell typically comprising Zinc Sulfide (ZnS), Zinc Selenide (ZnSe), Cadmium Sulfide (CdS) or combinations thereof. Core-shell quantum dots may comprise multiple shells or shell gradients.

The term **"perovskite crystals"** is known and particularly includes crystalline compounds of the perovskite structure. Such perovskite structures are known per se and described as cubic, pseudocubic, tetragonal or or-thorhombic crystals of general formula M¹M²X₃, where M¹ are cations of coordination number 12 (cuboctaeder) and M² are cations of coordination number 6 (octaeder) and X are anions in cubic, pseudocubic, tetragonal or orthorhombic positions of the lattice. In these structures, selected cations or anions may be replaced by other ions (stochastic or regularly up to 30 atom-%), thereby resulting in doped perovskites or nonstochiometric perovskites, still maintaining its original crystalline structure. Preferably, luminescent perovskite crystals are approximately isometric (such as spherical or cubic) . Particles are considered approximately isometric, in case the aspect ratio (longest : shortest direction) of all 3 orthogonal dimensions is 1 - 2. Accordingly, an assembly of LCs preferably contains 50 - 100 % (n/n), preferably 66 - 100 % (n/n) much preferably 75 - 100 % (n/n) isometric nanocrystals. The manufacturing of such luminescent perovskite crystals is known, e.g. from WO2018/028869, which is incorporated by reference.

The term **"micron-sized phosphors"** is known and particularly includes K2SiF6:Mn4+ (KSF)).

The term **"polymer"** is known and includes organic and inorganic synthetic materials comprising repeating units ("monomers"). The term polymers includes homo-polymers and co-polymers. Further, cross-linked polymers and non-cross-linked polymers are included. Depending on the context, the term polymer shall include its monomers and oligomers. Polymers include, by way of example, acrylate polymers, carbonate polymers, sulfone polymers, epoxy polymers, vinyl polymers, urethane polymers, imide polymers, ester polymers, furane polymers, melamine polymers, styrene polymers, norbornene polymers, silazane polymers, silicone polymers and cyclic olefin copolymers. Polymers may include, as conventional in the field, other materials such as polymerization initiators, stabilizers, and fillers.

The term **"color conversion film"** is known in the field. Color conversion films find wide application in commercial items such as displays. According to this invention, such films comprise a red and/or green color conversion material. According to this invention, such films partially or fully convert blue light into red and/or green light. Typically, the blue light is converted partially, resulting in emission of light in the blue, the green and/or the read spectrum. Upon adjusting intensity of blue light, and concentration, film thickness and amount of luminescent green and/or red material, the color of the emitted light may be adjusted in line with customer's needs.

Such color conversion films may be described as laminated structure and identified by its individual layers, such as "light emitting polymer layer", "red light emitting polymer layer", "green light emitting polymer layer", "first set of covering layers", "second set of covering layers", "inorganic sealing layer" and optionally "non-emissive polymer layer".

Further, such color conversion films may be identified by its individual surface areas, such as "top film area", "bottom film area", "first edge area", "second edge area", "third edge area", "fourth edge area".

Color conversion films typically have a film thickness, including all individual layers, of 10 - 500 micrometers, preferably 20 - 250 micrometers, most preferably 30 - 200 micrometers.

The present invention will be better understood by reference to the **figures.** In these figures, the following reference list applies:
- 010: color conversion film
- 010': native color conversion film, ie. without edge sealing layer
- 011: first edge area
- 013: second edge area
- 012: third edge area
- 014: forth edge area
- 020: stack of color conversion films
- 021: top film area
- 022: bottom film area
- 030: edge sealing layer (sealing layer on all edges of the native film 010')
- 030': surface sealing layer (sealing layer covering both major surfaces of the native film 010')
- 040: Free volume accessible to ALD process gases (e.g. gaseous metal-organic reactants and purging gases)
- 050: ALD chamber
- 070: additional layer
- 080: color conversion material converting blue light into light with longer wavelength
- 090: light emitting polymer layer
- 100: green color conversion material
- 110: green light emitting polymer layer
- 200: red color conversion material
- 210: red light emitting polymer layer
- 121: first set of covering layers
- 122: second set of covering layers

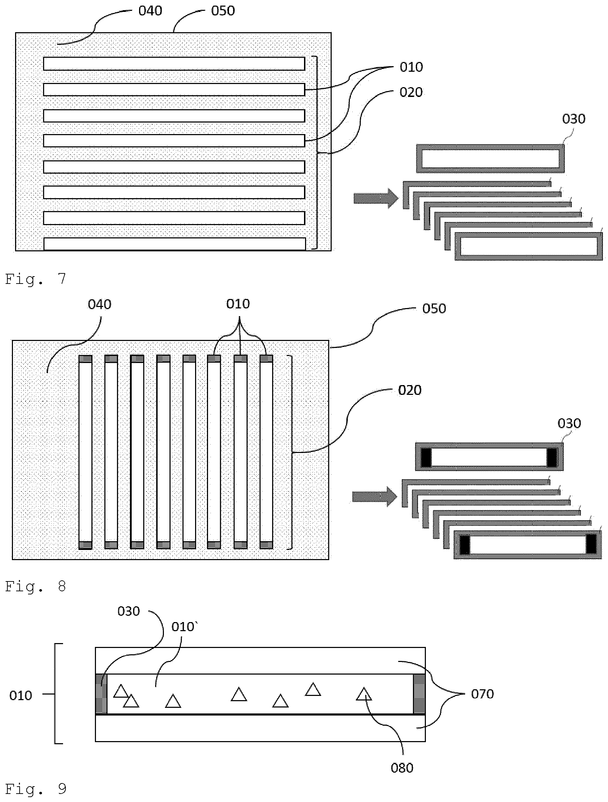

**Fig. 1** shows a rectangular native color conversion film prior to the inventive edge-treatment in perspective view. Major surface areas are indicated as 022 and 021, edges as 011 ... 014.
**Fig. 2** shows a rectangular color conversion film 010 after the inventive edge-treatment in top view; sealing layer 30 (not to scale) and native film 010' (no color conversion material shown) are labelled.
   The enlarged section on the right hand top shows a complete and defect free edge covering: Inorganic sealing layer homogenously covers a crack in the film 010' thus preventing oxygen and/or H2O to diffuse into color conversion film. The enlarged section on the right hand bottom shows for comparison an incomplete and defective edge covering: inorganic sealing layer, when deposited by directional vapour deposition techniques (e.g. CVD, DVD) . Due to shadowing effect, a crack in film 010' is not homogenously coated.

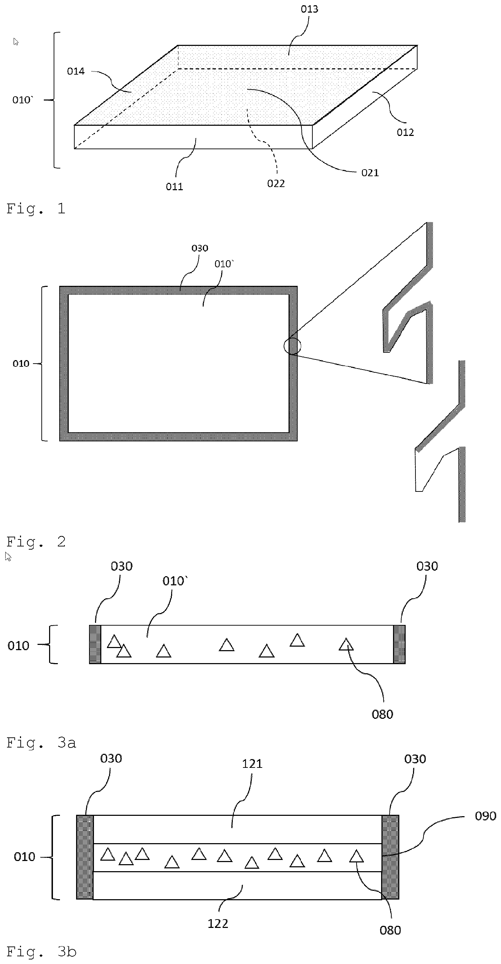

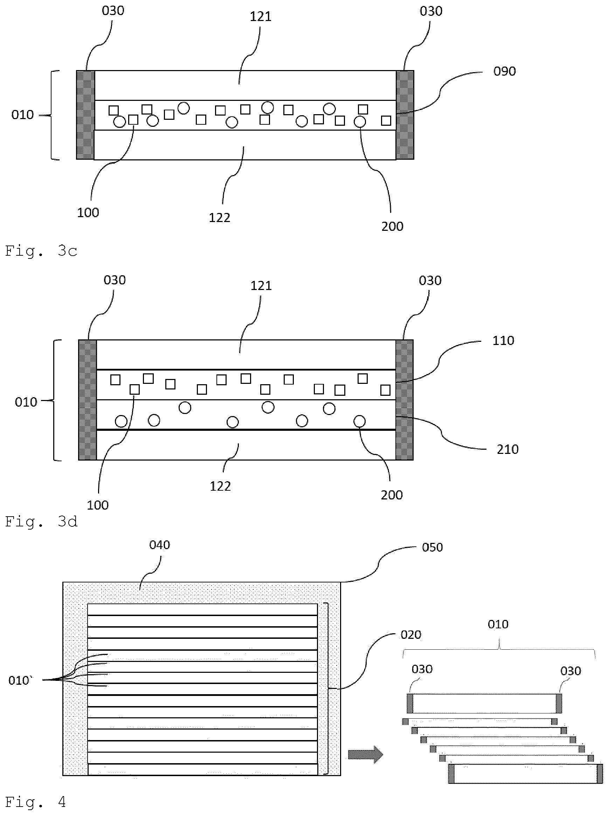

**Fig. 3** shows various inventive color conversion films in side view, thereby indicating the potential laminated structures
   3a: film of fig. 2 in side view. Such film will typically receive further treatment of both major surfaces 021 and 022, such as applying a covering layer 120, 121 to obtain laminated film structures as shown e.g. in 3b.
   3b: film of fig. 2 with additional conventional covering layers (e.g. barrier films) on major surfaces 3c: film of fig. 3b with two different types of color conversion material in one layer, see example 3.
   3d: film of fig. 2 with two different types of color conversion material in two separate layers, see example 1.
**Fig. 4** shows a manufacturing set up for inventive films 010. A stack of color conversion films 020, comprising a multitude of individual native films 010' are located in ALD chamber 040. The stack 020 is adapted to seal the edges of as many color conversion films as possible in one ALD batch and secondly to reduce ALD process gases to come into contact with major surfaces (except for top surface of the stack 020. This setup allows sealing of all edges but no sealing, or very limited sealing, of major surfaces, as indicated on the right hand, to thereby obtain a multitude of inventive edge-sealed color conversion films 010.

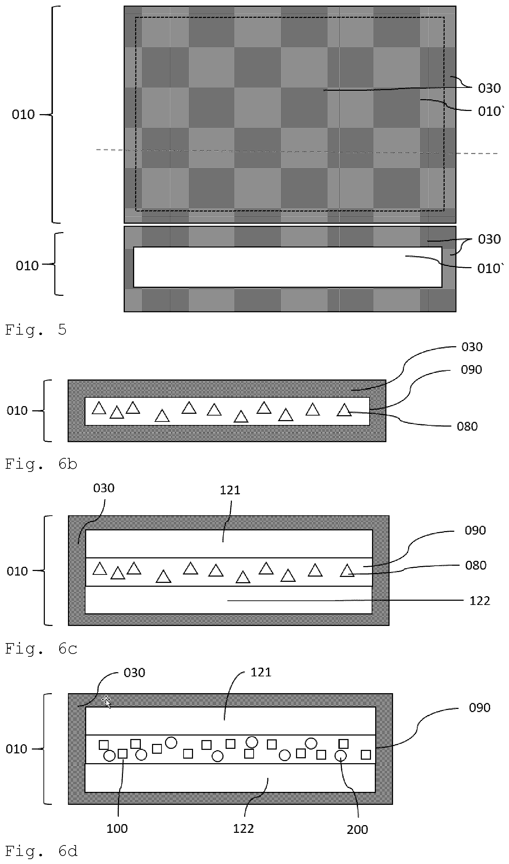

**Fig. 5** shows a rectangular color conversion film 010 after the inventive treatment of edges and major surfaces in top view and side view, i.e. cut through along the dotted horizontal line. Sealing layer 30 (not to scale) and native film 010' are labelled. As indicated, sealing layer thickness on edges and on major surfaces may differ. In this embodiment shown, edge sealing is of lower thickness than major surface sealing.

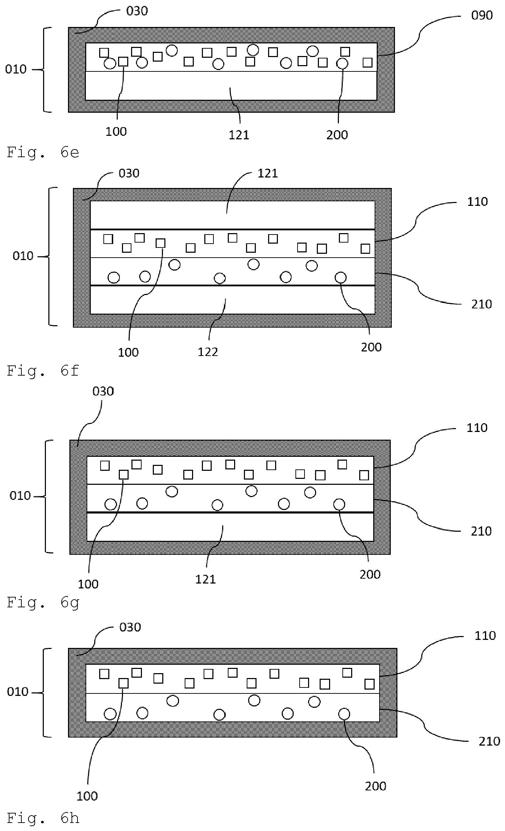

**Fig. 6** shows various inventive color conversion films in side view, thereby indicating the potential laminated structures which are sealed on all edges and both major surfaces with the inventive sealing layer 30 (again not to scale).
   6b: simple film, coated on edges and major surfaces
   6c: film as in 6b but with additional conventional set of covering layers 122 and 121
   6d: film as in 6c but with two different types of color conversion material 100 and 200
   6e: film as in 6d but with one conventional set of covering layer only
   6f: film as in 6d but with red and green light emitting layers separated in individual layer 110 and 210
   6g: film as in 6f but with one conventional set of covering layer 121 only
   6h: film as in 6b but with red and green light emitting layers separated in individual layer 110 and 210
**Fig. 7** shows a manufacturing set up for inventive films 010 comprising sealing layers on all edges and both major surfaces as shown in fig. 6. A modified stack of color conversion films 020', comprising a multitude of individual native films 010' are located in ALD chamber. The stack 020'is adapted to allow ALD process gases to come into contact with major surfaces and edges. This setup allows sealing of all edges 030 and sealing of major surfaces 030' as indicated on the right hand to thereby obtain a multitude of inventive edge-sealed and face-sealed color conversion films 010.
**Fig. 8** shows an alternative manufacturing set up for inventive films 010 compared to fig. 7. An edge sealed film is subjected to an additional ALD step.
**Fig. 9** shows an inventive film 10, comprising additional layers 070, such layer 070 being free of edge-sealing 030.

In a **first aspect** the invention refers to a color conversion film 010 which upon excitation by blue light emits light in the visible range, preferably red and/or green light. Such films comprise a native film (010', free of edge sealing), having two major surfaces (021, 022) and at least one edge 011 .. 014 and comprise a color conversion material 80, 100, 200. Such films further comprise an inorganic sealing layer 030 on all edge areas whereby the inorganic sealing layer is an atomic layer deposited layer which covers all edge areas completely with very high thickness uniformity. This aspect of the invention shall be explained in further detail below.

### edge sealing layer 030:

In the context of the present invention, sealing layers 030 have the following properties:
- They completely cover the edges of a film 010') without defects or pinholes.
- They have a thickness of 1 - 500 nm, preferably 3 - 200nm, most preferably 10 - 100nm.
- They have a very uniform thickness over the whole coated substrate characterized by a standard deviation of thickness variation over the whole substrate of less than 10%, preferably less than 3%, most preferably less than 1%.
- They contain, particularly consist of, inorganic material.

The thickness of inorganic sealing layers can be determined by transmission electron microscopy (TEM), preferably on a microtome-prepared sample. Without being bound to theory, it is believed that thickness and standard deviation thereof are characteristics of the ALD manufacturing step described herein.

The "complete and defect-free" coverage can be deducted by the stability of the color conversion film after accelerated degradation test. The language "complete and defect-free" was chosen to distinguish from incomplete and defective coatings, as obtained e.g. by directional vapour deposition techniques (e.g. CVD, PVD). Due to shadowing effects, such directional vapour deposition techniques do not ensure a complete and defect-free coverage of a surface.

When applying ALD manufacturing to the film edges 011 .. 014, some inorganic material may be deposited on the major surfaces 021, 022. This will result in an additional coating on part of the major surface. Such partial coating on the major surfaces does not negatively impart film properties and is encompassed in the present invention. This partial coating is not shown in schematic figures discussed herein.

The term "inorganic material" is known in the field. Given the ALD manufacturing method described below, preferred inorganic materials are selected from the group of metal oxides or metal nitrides. More preferably selected from the group of Silicon oxide, Aluminum oxide, Zirconium oxide, Hafnium oxide or Titanium oxide (e.g. SiOₓ with x = 1.9-2.1, AlOₓ with x=1.4-1.6, TiOₓ with x=1.9-2.1, ZrOₓ with x=1.9-2.1, HfOₓ with x=1.9-2.1). They may consist of only one inorganic material or more than one inorganic material (e.g. multilayers of different inorganic layers with different chemical composition). The ALD manufacturing results in very pure inorganic layers. However, some residual organic material from precursor material may be present. Thus, reference to a layer of inorganic material refers to a purity of > 95wt%, typically > 99wt%, such as > 99.5wt%.

The composition of an inorganic sealing layer can be determined by X-Ray photoelectron spectroscopy (XPS) or TEM equipped with EDX spectroscopy (EDX analysis on a cross-section of the inorganic sealing layer).

In one embodiment the inorganic sealing layer consists of alternating layers of two different metal oxides whereby preferably the number of individual metal oxide layers is more than 2, more preferably more than 3, most preferably more than 5.

In a further embodiment the inorganic sealing layer comprises alternating layers of the following combinations of different metal oxides:
- AlOx / TiOx
- AlOx / SiOx
- AlOx / ZrOx
- AlOx / HfOx
- TiOx / SiOx
whereby preferably the first named oxide layer has a thickness of 3 - 100nm (preferably 10 - 50nm) and preferably the second named oxide layer which has a thickness of 2 - 50 nm (preferably 5 - 20 nm).

In a further embodiment the inorganic sealing layer comprises the following layer sequence:
- AlOₓ / MOₓ with M = Si, Zr, Ti, Hf
whereby preferably the aluminum oxide layer has a thickness of 3 - 100nm (preferably 10 - 50nm) and preferably the MOx layer has a thickness of 2 - 50 nm (preferably 5 - 20 nm).

Preferably, inorganic sealing layers are applied to the edges, and optionally major surfaces, of a film by atomic layer deposition (ALD) techniques. ALD is a coating technique known per se but, not yet applied in the context described herein. Accordingly, the invention also provides for a color conversion film 010 which upon excitation by blue light emits light in the visible range, preferably red and/or green light. Such films comprise a native film (010', free of edge sealing), having two major surfaces 021, 022 and at least one edge 011 .. 014 and comprise a color conversion material 80, 100, 200. Such films further comprise an inorganic sealing layer 030 on all edge areas whereby the inorganic sealing layer is an ALD-deposited inorganic layer covering all edge areas.

### Surface sealing layer 030'.

In the context of the present invention, in addition to the edge sealing layer 030 covering all edges, one or two sealing layers 030', covering either one or both of the major surfaces, may be present. Such surface sealing layer(s) 030', if present, have the following properties:
- They completely cover either one or both major surfaces of a film 010' without defects or pinholes.
- They have a thickness of 1 - 500 nm, preferably 3 - 200nm, most preferably 10 - 100nm.
- They have a very uniform thickness over the whole coated substrate characterized by a standard deviation of thickness variation over the whole substrate of less than 10%, preferably less than 3%, most preferably less than 1%.
- They contain, particularly consist of, inorganic material.

Regarding the above properties, particularly definition of inorganic material, defect-free coverage, layer architecture, thickness and its standard deviation, of surface sealing layer 030', the same considerations as above for edge sealing 030 apply.

In embodiments, the average thickness of the surface sealing 030' is lower than the average thickness of the edge sealing 030, for example at least 2 times lower; preferably at least 5 times lower.

### Color conversion material:

The term color conversion material is defined above.

In one embodiment of this invention the red color conversion material emits red light (630 nm +/- 30 nm) in response to excitation by light of a shorter wavelength and is preferably selected from core-shell quantum dots or perovskite crystals. The core-shell quantum dots preferably are selected from core-shell quantum dots comprising Indium or Cadmium, most preferably Indium.

The green color conversion material emits green light (500 - 550nm, in particular centered around 525 - 535nm) in response to excitation by light of a shorter wavelength and is preferably selected from core-shell quantum dots or perovskite crystals, preferably perovskite crystals.

The perovskite crystals are selected from compounds of formula (I):

[M¹A¹]ₐM²_{b}X_{c} (I),

wherein:
A¹ represents one or more organic cations, in particular formamidinium (FA),
M¹ represents one or more alkaline metals, in particular Cs,
M² represents one or more metals other than M¹, in particular Pb,
X represents one or more anions selected from the group consisting of halides, pseudohalides and sulfides, in particular Br,
a represents 1-4,
b represents 1-2,
c represents 3-9, and
wherein either M¹, or A¹, or M¹ and A¹ being present.

In a further advantageous embodiment of the invention the green luminescent crystals are green luminescent perovskite crystals of formula (I'): FAPbBr₃ (I').

In particular, formula (I), (I') describe perovskite luminescent crystals, which, upon absorption of blue light, emit light of a wavelength in the green light spectrum between 500 nm and 550 nm, in particular centered around 525 - 535 nm.

### Light emitting polymer layer 090:

A light emitting polymer layer 090 comprises a color conversion material 080 (preferably red and / or green) distributed within a polymer.

Suitable color conversion materials 080 are defined above. Suitable polymers may be selected from the group of acrylates, methacrylates, epoxies, silazanes, urethanes, preferably acrylates and methacrylates. In embodiments such polymers are crosslinked. In embodiments, a combination / blend of more than one polymer is used.

Suitably, light emitting polymer layers have a thickness of 10 - 200 micrometers, preferably 20 - 100 micrometers.

### Green light emitting polymer layer 110:

A green light emitting polymer layer comprises a polymer and a green color conversion material 100 distributed within such polymer.

Suitable green color conversion materials 100 may be selected from the group of perovskite crystals and core-shell quantum dots comprising Indium; preferably perovskite crystals.

Suitable polymers may be selected from the group of acrylates, methacrylates, epoxy, silazanes, urethanes, preferably acrylates and methacrylates. In embodiments such polymers are crosslinked. In embodiments, a combination / blend of more than one polymer is used.

Suitably, green light emitting polymer layers have a thickness of 10 - 200 micrometers, preferably 20 - 100 micrometers.

### Red light emitting polymer layer 210:

A red light emitting polymer layer comprises a polymer and a red color conversion material 200 distributed within such polymer

Suitable red color conversion materials 200 include red perovskite crystals or core-shell quantum dots comprising Indium, preferably core-shell quantum dots comprising Indium.

Suitable polymers may be selected from the group of acrylates, methacrylates, epoxies, silazanes, urethanes, preferably acrylates and methacrylates. In embodiments polymers are crosslinked. In embodiments, a combination / blend of more than one polymer is used. In embodiments the polymer comprises a mono-functional polycyclic acrylate or methacrylate and a multi-functional acrylate or methacrylate.

Suitably, red light emitting polymer layers have a thickness of 10 - 200 micrometers, preferably 20 - 100 micrometers.

### First and second set of covering layers 121, 122:

Adjacent to the light emitting polymer layer(s), covering layers 121, 122 may be present. A first and second set of covering layers each independently may comprise a single layer or a multitude of layers whereby such layers maybe inorganic or polymeric and are non-emissive (meaning they do not emit light when excited by blue light). Covering layers may have different functions and may be selected from:
- Barrier films/layers
- Intermediate films/layers
- Adhesive films/layers
- Light management films/layers
- Non-emissive polymer film/layers

**Barrier films/layers:** In the context of the present invention, barrier films exhibit a low permeation rate for oxygen and/or humidity. Such barrier films may be selected from inorganic barrier films or polymeric barrier films having an oxygen transmission rate (OTR) of less than 10 cm3/m2*day, preferably less than 1 cm3/m2*day, most preferably less than 0.1 cm3/m2*day. OTR determined by ISO15105 at a temperature of 23°C / 90% r.h. and atmospheric pressure and/or having a water vapor transmission rate (WVTR) of less than 10 g/m2*day, preferably less than 1 g/m2*day, most preferably less than 0.1 g/m2*day. WVTR may be determined by ISO 15106-3:2003 at a temperature/relative humidity of 40°C /90%r.h.

Inorganic barrier films comprise or consist of a continuous layer of inorganic material. Typically the thickness of such layer is 1 nm - 10 micrometers, preferably 10 nm - 1 micrometer. Suitable inorganic materials include, without limitation, SiOₓ (x=1.7-2.3), AlOₓ (x=1.3-1.7), and SiₓN_{y} (x=3 and y=3.5-4.5).

Polymeric barrier films consist of a polymer or polymer blend and have a typical thickness of 5 - 200 micrometers, preferably 10 - 100 micrometers, most preferably 20 - 50 micrometers.

Inorganic and polymeric barrier films may be commercial items and may be supported by an additional polymer substrate.

**Intermediate films/layers:** Intermediate layers can be implemented in color conversion films to further improve the stability of color conversion materials (typically of perovskite crystals), to separate specific layers to avoid contact of such specific layers or to facilitate the manufacturing of the color conversion film thus e.g. lowering manufacturing costs.

Intermediate layers comprise or consist of polymers. Suitable polymers are selected from the list of acrylate or methacrylate polymer, epoxy polymer, silazane polymer, cyclic olefin copolymer, polyester, preferably acrylate polymer or methacrylate polymer.

In embodiments such polymers are crosslinked.

Intermediate layers have a thickness of 5 - 100 micrometers, preferably 10 - 80 micrometers, most preferably 20 - 60 micrometers.

**Adhesive films/layers:** Such layers are known in the field and may be included in the color conversion film to improve compatibility between layers, or to improve adhesion between layers, or to facilitate manufacturing.

Typically such layers are used on barrier films to improve the adhesion of adjacent polymeric layers such as intermediate layers or light emitting polymer layers.

Such layers have a typical thickness of 0.1 - 20 micrometers, preferably 0.5 - 10 micrometers, most preferably 1 - 5 micrometers.

In embodiments such layers consist of a polymer or polymer blend.

Typical polymers are selected from the list of acrylate or methacrylate polymers, epoxy polymers, urethane polymers.

**Light management films/layers:** Light management films/layers are sometimes used in color conversion films to e.g. increase the light output of color conversion films or reflect a specific portion of light.

Light management films include prism sheets, brightness enhancement films, micro lens array (MLA) films (such films are e.g. supplied by Brightview Technologies), blue light pass filter films (also called dichroic mirror films; such films transmit blue light and reflect green and red light; such films are supplied by 3M and are used in the Apple iPad Pro XDR from 2021) .

MLA films typically have a thickness of 10 - 50 micrometer. Dichroic mirror films typically have a thickness of 20 - 100 micrometers.

### Film geometry:

In one embodiment the color conversion film has a rectangular shape. The length and width of this film is similar to typical LCD displays, e.g. ranging from mobile phone dimensions to TV dimensions. This includes an aspect ratio 4:3, 3:2, 16:9 or 3 : 1 and a diagonal of 5 cm to 250 cm. As conventional in the field, rectangular shaped films may comprise minor deviations from the strict geometrical meaning of "rectangular". For example, edges may be rounded or notches may be present to adapt the film to its intended use or to facilitate manufacturing of devices. In embodiments, the color conversion film has a rectangular shape with rounded angles. Such rounded edges typically have a radius of < 5 mm. In embodiments, the edges of a rectangular-shaped color conversion film exhibit one or more small geometrical features standing slightly out from the edge (such edge features, also termed "notches", are implemented in the edges to keep the color conversion film in the display backlight in place and avoid unwanted rearrangement of the film). It was found that the inventive method for edge sealing is also applicable to such rounded edges and to edges with additional geometrical features. This is considered an additional benefit of the inventive method described below.

In embodiments, the color conversion film is disk-shaped, thereby only having one edge 011 separating major surfaces 021 and 022. It was found that the inventive method for edge sealing is also applicable to such non-traditional shapes.

### Film Architecture:

Within the scope of the invention, various laminated structures (film architectures), may be implemented. These architectures share the common feature that at least the light emitting polymer layers 090, 110, 210 are sealed on all edges with inorganic sealing layer 030.

**Referring to** **figs. 1 and 2****,** the color conversion film 010 comprises an inorganic sealing layer 030 on all four edge areas 011 ... 014 whereby the inorganic sealing layer covers all four edge areas completely and whereby the thickness standard deviation including all four edges is less than 10%, preferably less than 3%, most preferably less than 1%.

**Referring to** **figs. 3a -3d****,** the color conversion film 010 comprises an inorganic sealing 030 covering all edges ("edge sealing"). In this embodiment, the film has no, or essentially no inorganic coating on its major surfaces. This is achieved by the method described below, providing a stack 20 where a direct contact of films 010' is provided or where films 010'are separated by auxiliary separating films. The skilled person is aware that manufacturing via ALD deposition nevertheless may result in some inorganic covering on the major surfaces, due to diffusion effects of the ALD process gasses. However, such diffusion process do not result in a complete coverage of the major surface. To reflect this situation, the language no, or essentially no coating was chosen. Such embodiment may be obtained when following the ALD process according to fig. 4.

**Referring to** **figs. 6b** - **6g** the color conversion film 010 has in addition to the inorganic sealing 030 covering all edges ("edge sealing") an inorganic sealing 030' covering both major surfaces ("surface sealing").

In embodiments, the average thickness of the surface sealing 030' is lower than the average thickness of the edge sealing 030 (at least 2 times lower; preferably 5 times lower). Such embodiment may be obtained when following the ALD process according to fig. 8.

In embodiments, the surface sealing 030'and the edge sealing 030 have essentially the same thickness, the difference being less than 10%, preferably less than 3%, most preferably less than 1%. In this embodiment, film thickness may be in the range of 1 - 500nm, preferably 10 - 100nm. Such embodiment may be obtained when following the ALD process according to fig. 7.

Preferably, both the native color conversion film 010'and the inventive color conversion film 010 are freestanding films. The inventive film having improved properties when assembled into a display device.

**Referring to** **fig. 9****,** it is within the scope of the invention that the inventive color conversion film 010 (comprising an edge sealing 030 and optionally surface sealing 030') may additionally comprise one or more layers on the top and/or bottom whereby (Additional layer 070). Such additional layer(s) do not contain an inorganic sealing layer on the edge areas. If present, such additional layers may be any layer selected from:
- Glass substrates
- Barrier films/layers
- Intermediate films/layers
- Adhesive films/layers
- Light management films/layers
- Non-emissive polymer film/layers

This embodiment, showing additional layer 070, is obtainable if finishing step (d) is an additional laminating step.

### Advantageous embodiments:

In line with the present disclosure, the following inventive films 010 are considered particularly advantageous.

In one embodiment the color conversion film comprises only one type of color conversion material 080, either a red color conversion material 200 or a green color conversion material 100, preferably a green color conversion material. (see e.g. figs. 3a, 3b, 6b, 6c, 9)

In a further embodiment the color conversion film comprises a green color conversion material and a red color conversion material. (see e.g. figs. 3c, 6d)

In a further embodiment the color conversion film comprises a green color conversion material selected from the list of perovskite crystals, core-shell quantum dots comprising Indium or core-shell quantum dots comprising Cadmium, preferably perovskite crystals.

In a further embodiment the color conversion film comprises a red color conversion material selected from the list of perovskite crystals, core-shell quantum dots comprising Indium or core-shell quantum dots comprising Cadmium, preferably core-shell quantum dots comprising Indium or perovskite crystals, most preferably core-shell quantum dots comprising Indium.

In a further embodiment the color conversion film comprises a green color conversion material selected from perovskite crystals and a red color conversion material selected from core-shell quantum dots comprising Indium.

In a further embodiment the green color conversion material and the red color conversion material are present in different polymer layers; the green color conversion material being present in a green light emitting polymer layer and the red color conversion material being present in one or more red light emitting polymer layer(s). (see e.g. figs. 6f, 3d)

In a further embodiment the color conversion film is comprising a first set of covering layers and a second set of covering layers whereby the color conversion material(s) are located between these two sets of covering layers. (see e.g. figs. 3b, c, d)

In a further embodiment the color conversion film is comprising a first set of covering layers and a second set of covering layers whereby the color conversion material(s) are located between these two sets of covering layers and whereby both sets of covering layers each are comprising at least one barrier film, preferably at least one inorganic barrier film.

In a further embodiment the color conversion film 010 comprises edge sealing 030 and surface sealing 030' but no additional layer 070, 121, 122. (see e.g. fig. 6b and 6g)

In a further embodiment the color conversion film 010 comprises edge sealing 030 and surface sealing 030' and one set of covering layers 121 or 122. (see. e.g. fig. 6e). Preferably, the one set of covering layers 121 or 122 comprises or consists of a polymer film, most preferably of a PET film.

In a further embodiment the color conversion film comprises one or more intermediate layers or one or more adhesive layers between the one or more light emitting polymer layers and the one or more sets of covering layers.

In a further embodiment the color conversion film compri ses a green light emitting polymer layer and a red light emitting polymer layer which are separated by one or more inorganic barrier films.

In a further embodiment the color conversion film comprises a green light emitting polymer layer and a red light emitting polymer layer which are separated by a polymer film, preferably a PET film.

In a further embodiment the color conversion film comprises a dichroic mirror film (blue light pass filter film) in one of a first or second set of covering layers 121, 122.

In a further embodiment the color conversion film comprises a microlens array film (MLA) in one of a first or second set of covering layers 121, 122.

In a further embodiment the color conversion film comprises a dichroic mirror film (blue light pass filter film) in covering layer 121 and a microlens array film (MLA) in the covering layer 122.

In a further embodiment, inventive films comprise the following layer sequence: Barrier film / green light emitting polymer layer / barrier film.

In a further embodiment, inventive films comprise the following layer sequence: Barrier film / intermediate layer / green light emitting polymer layer / intermediate layer / barrier film.

In a further embodiment, inventive films comprise the following layer sequence: Barrier film / light emitting polymer layer containing a red and green color conversion material / barrier film.

In a further embodiment, inventive films comprise the following layer sequence: Barrier film / green light emitting polymer layer / red light emitting polymer layer / barrier film.

In a further embodiment, inventive films comprise the following layer sequence: PET covering layer / green light emitting polymer layer / PET covering layer.

In a further embodiment, inventive films comprise the following layer sequence: PET covering layer / light emitting polymer layer containing a red and green color conversion material / PET covering layer.

In a further embodiment, inventive films comprise the following layer sequence: PET covering layer / green light emitting polymer layer / red light emitting polymer layer / PET covering layer.

In a further embodiment, inventive films comprise the following layer sequence: Barrier film / intermediate layer / green light emitting polymer layer / red light emitting polymer layer / barrier film.

In a further embodiment, inventive films comprise the following layer sequence: Intermediate layer / green light emitting polymer layer / red light emitting polymer layer.

In a further embodiment, inventive films comprise the following layer sequence: Intermediate layer / green light emitting polymer layer / red light emitting polymer layer / intermediate layer.

In a further embodiment, inventive films comprise the following layer sequence: green light emitting polymer layer comprising perovskite crystals / red light emitting polymer layer comprising core-shell quantum dots comprising Indium.

In a further embodiment, inventive films comprise the following layer sequence: Intermediate layer comprising acrylate polymer or methacrylate polymer / green light emitting polymer layer comprising perovskite crystals / red light emitting polymer layer comprising core-shell quantum dots comprising Indium.

In a further embodiment, inventive films comprise the following layer sequence: Barrier film / light emitting polymer layer comprising green core-shell quantum dots comprising Indium and red core-shell quantum dots comprising Indium / barrier film.

In a further embodiment, inventive films comprise the following layer sequence: PET film / light emitting polymer layer comprising green core-shell quantum dots comprising Indium and red core-shell quantum dots comprising Indium / PET film.

### Industrial Applicability:

Color conversion films of this invention may be assembled to obtain a display backlight component. Accordingly, the invention also provides for a display backlight component comprising a color conversion film as described herein.

Color conversion films of this invention may be assembled to obtain a light emitting device, such as a liquid crystal display. Accordingly, the invention also provides for a light emitting device, preferably a Liquid crystal display, comprising a color conversion film as described herein.

**In a second aspect** the invention refers to a method for manufacturing a color conversion film as described herein. Generally speaking, the method involves the step of applying atomic layer deposition (ALD) with multiple ALD cycles on a multitude of stacked color conversion films 020 in an ALD batch reactor 050. By such ALD process an inorganic sealing layer 030 on all edge areas, and optionally additionally on the top and bottom film area 030', is obtained. Thus, the invention relates to a method for manufacturing a color conversion film according to the previous claims comprising the steps of: (a) providing a multitude of native color conversion films (010') and assembling them to a stack (020); (b) subjecting the stack of step (a) to a first ALD process to thereby obtained a stack of sealed color conversion films (010); (c) optionally repeating steps (a) and (b) to thereby obtain a multi-sealed color conversion film; (d) optionally subjecting the sealed or multi-sealed color conversion film to finishing steps.

This shall be explained in further detail below.

In order to effectively seal all four edges 011 ... 014 of color conversion films (rectangular shaped) with a very thickness-uniform inorganic layer that completely covers the surface of all four edge areas without pinholes or other defects and with completely covered cracks (also at the crack inside) we found that atomic layer deposition (ALD) is highly advantageous. In comparison, traditional chemical and physical vapour deposition methods are disadvantageous because they exhibit a directional deposition of inorganic materials which:
- Is prone to shadowing effects. This means that e.g. cracks or other defects on color conversion film edge areas are not coated with a homogeneous inorganic layer (see figure 2) thus allowing oxygen and/or H2O to diffuse into the color conversion film resulting in edge ingress.
- Makes it impossible to deposit a inorganic layer with homogenous thickness on all four edge areas of the color conversion film in one processing step.

ALD on the other hand enables inorganic layers with homogenous thickness on all four edge areas with one single ALD treatment and cracks/defects are completely covered with such a homogeneous inorganic layer because ALD is not prone to shadowing effects. It comes as a surprise that ALD achieves these positive results, considering the teaching of Nehm et al, cited above.

Furthermore a cost-effective ALD batch process was found to efficiently deposit homogenous inorganic layers on all four edge areas with multiple color conversion films at the same time. Furthermore this ALD batch process optionally also allows to additionally deposit such homogeneous inorganic layers on the top and bottom film area (see figure 5-7b) which allows to make color conversion films even more stable against oxygen and/or humidity or allows the avoidance of expensive barrier films (typically existing of an inorganic layer on a PET substrate) during the manufacturing of the native color conversion film.

In view of the above, the methods A, B and C, elucidated below, are particularly suitable for obtaining an inventive film 010 comprising a sealing layer 030 providing a complete and defect-free covering of the edges and optionally an additional sealing layer 030' providing a complete and defect-free covering of the major surfaces.

**Method A,** c.f. fig. 4: In one embodiment, the color conversion films before the ALD process do not contain an inorganic sealing layer on all four edge areas or top and bottom film areas yet (i.e. native color conversion film 010') and are in physical contact either with other color conversion films (c.f. fig.4) or with separating films (not shown). This method results in color conversion films whereby all four edge areas are covered with an inorganic sealing layer 030 after the ALD process, but the top and bottom film are not, or essentially not, covered. As discussed above, diffusion effects may result in partial coverage of surface area adjacent to the edges. Such side effect is not shown in the figures and does not negatively impart film properties.

Separating films (not shown) can be used to either avoid direct contact of different color conversion films or to minimize the diffusion of ALD precursor into the interface between two color conversion films thus minimizing the deposition of an inorganic layer on the top and bottom film area discussed above. Suitable separating films are polymer films or metallic films. Preferably soft polymer films such as elastomeric polymer films (e.g. PDMS) or other soft polymer films (e.g. PTFE).

**Method B,** c.f. fig. 5: In a further embodiment the color conversion films before the ALD process do not contain an inorganic sealing layer on all four edge areas or top and bottom film areas yet and are separated by an air-gap. This results in color conversion films 010 whereby all edge areas and both top and bottom film area are covered with an inorganic sealing layer after 030, 030' after step b of the ALD process.

**Method C,** c.f. fig. 8: The color conversion film of method A is subjected to an additional ALD step. In this further step, in the stack 020 the films 010 are separated by a gap permeable to ALD process gases 040. This method provides inventive films 010 comprising edge sealing 030 on all edges and surface sealing 030' on both major surfaces and with thickness 030 > thickness 030'.

### Atomic layer deposition (ALD):

A key feature of the present invention is the implementing of ALD for manufacturing layer 030 (step b) and optionally layer 030' in step (b) or (c).

Atomic layer deposition (ALD) is a well-known manufacturing method. It must be distinguished from chemical vapor deposition (CVD) . (ALD) is a thin-film deposition technique based on the sequential use of a gas-phase chemical process. In the context of this invention, ALD reactions use two gaseous chemical precursors (also called "reactants"). These precursors react with the surface of a material one at a time in a sequential, self-limiting, manner. A thin film is slowly deposited through repeated exposure to separate precursors. Accordingly, during ALD a film is grown on a substrate by exposing its surface to alternate gaseous species (i.e. the ALD precursors or ALD reactants, respectively). In contrast to chemical vapor deposition (CVD), the precursors are never present simultaneously in the reactor, but they are inserted as a series of sequential, non-overlapping pulses. In each of these pulses the precursor molecules react with the surface in a self-limiting way, so that the reaction terminates once all the reactive sites on the surface are consumed. Consequently, the maximum amount of material deposited on the surface after a single exposure to all of the precursors (a so-called ALD cycle) is determined by the nature of the precursor-surface interaction. By varying the number of cycles it is possible to grow materials uniformly and with high precision on arbitrarily complex and large substrates.

ALD manufacturing steps therefore produce very thin, conformal films with control of the thickness and composition of the films possible at the atomic level. In order to determine the thickness of deposited ALD layers per specific number of ALD cycles, ALD layers can be deposited on silicon substrates and then the layer thickness can be determined by X-ray reflectometry and ellipsometry.

In a further embodiment the ALD process is conducted at 50 - 170°C, preferably 60 - 140°C, most preferably 70 - 120°C. Such reaction conditions are considered advantageous, as compatible with polymer materials present in film 010'.

In a further embodiment the ALD process is conducted at below 10 mbar, preferably below 1 mbar, most preferably below 0.1 mbar. These conditions allow reliable reaction of reactants with the surface in a self-limiting way.

The ALD process comprises at least one ALD cycles, typically more than one ALD cycle, whereby one ALD cycle comprises the following steps:
b1. Introduction of first reactant into ALD reaction chamber. In this step, the first reactant is adsorbed on the edges 011 .... 014 and optionally on the major surfaces 021, 022;
b2. Optionally purging the reaction chamber with a purging gas. In this step, non-adsorbed first reactant is removed.
b3. Introduction of second reactant into ALD reaction chamber. In this step, the reaction with the first reactant, which is adsorbed on the substrate, takes place.
b4. Optionally purging the reaction chamber with a purging gas. In this step, non-reacted second reactant is removed.

In one embodiment, 1 - 100 cycles, preferably 5 - 20 cycles are implemented in step b.

In an embodiment the **first reactant** for the ALD process is a metal-containing compound with a molecular weight of less than 500 g/mol, preferably less than 300 g/mol. In a further embodiment the first reactant for the ALD process is selected from the list of metal chlorides, metal alkoxides, metal alkyls and metal alkylates. In a further embodiment the first reactant for the ALD process is a metal-alkyl, metal-alkoxyl or a metal-chloride compound comprising Silicon, Aluminum, Titanium, Zirconium or Hafnium, preferably Aluminum. In a further embodiment the first reactant for the ALD process is selected from the list of AlCl3, TiCl4, ZrCl4 SiCl4, Al-isopropoxide, Ti-isopropoxide, Al(CH3)3, Ti(CH3)4, Si(CH3)4; preferably Al(CH3)3, Ti(CH3)4 and Si(CH3)4. Such starting materials are commercial items and may be used as purchased.

In an embodiment the **second reactant** is selected from the group consisting of H₂O or ozone.

In a further embodiment the **purging gas** is nitrogen or CO₂, preferably nitrogen.

### Examples

### Comparative example 1 (un-sealed film with red and green light emitting layer):

A color conversion film comprising a green light emitting polymer layer with perovskite crystals and a red light emitting polymer layer with core-shell quantum dots comprising Indium whereby is prepared as described below. This color conversion film does not contain a sealing layer on the edge areas.

### Manufacturing, comp.ex.1:

Formation of green coating formulation: Green perovskite luminescent crystals with composition formamidinium lead tribromide (FAPbBr₃) are synthesized in toluene as following: Formamidinium lead tribromide (FAPbBr₃) was synthesized by milling PbBr₂ and FABr. Namely, 16 mmol PbBr₂ (5.87 g, 98% ABCR, Karlsruhe (DE)) and 16 mmol FABr (2.00 g, Greatcell Solar Materials, Queanbeyan, (AU)) were milled with Yttrium stabilized zirconia beads (5 mm diameter) for 6 h to obtain pure cubic FAPbBr₃, confirmed by XRD. The orange FAPbBr₃ powder was added to Oleylamine (80-90, Acros Organics, Geel (BE)) (weight ratio FAPbBr₃:Oleylamine = 100:15) and toluene (>99.5 %, puriss, Sigma Aldrich). The final concentration of FAPbBr₃ was 1wt%. The mixture was then dispersed by ball milling using yttrium stabilized zirconia beads with a diameter size of 200 µm at ambient conditions (if not otherwise defined, the atmospheric conditions for all experiments are: 35°C, 1 atm, in air) for a period of 1h yielding an ink with green luminescence.

0.1 g of the green ink was mixed with an UV curable monomer/crosslinker mixture (0.7 g FA-513AS, Hitachi Chemical, Japan / 0.3 g Miramer M240, Miwon, Korea) containing 1wt% photoinitiator Diphenyl(2,4,6-trimethylbenzoyl) phosphine oxide (TCI Europe, Netherlands) and 2 wt% polymeric scattering particles (Organopolysiloxane, ShinEtsu, KMP-590) in a speed mixer and the toluene was evaporated by vacuum (<0.01 mbar) at room temperature.

Formation of green light emitting polymer layer: The resulting green coating formulation was then coated with 50 micron layer thickness on a 25 micron barrier film (supplier: I-components (Korea); film architecture: PET substrate / SiOx layer / adhesive layer) on the side of the adhesive layer, then laminated with a 100 micron PET film. Afterwards the laminate structure was UV-cured for 60 s (UVAcube100 equipped with a mercury lamp and quartz filter, Hoenle, Germany). The initial performance of the as obtained film showed a green emission wavelength of 526 nm with a FWHM of 22 nm.

Formation of red coating formulation: 0.1g red luminescent crystals being isometric core-shell QDs having an InP core and a ZnS shell (1 wt% suspended in toluene) were mixed with an UV curable monomer/crosslinker mixture (0.5 g FA-DCPA, Hitachi Chemical, Japan / 0.5 g Miramer M2372, Miwon, Korea) containing 1wt% photoinitiator Diphenyl(2,4,6-trimethylbenzoyl) phosphine oxide (TCI Europe, Netherlands) and 2 wt% polymeric scattering particles (Organopolysiloxane, ShinEtsu, KMP-590) in a speed mixer and the toluene was evaporated by vacuum (<0.01 mbar) at room temperature.

Formation of red light emitting polymer layer: First the PET film was peeled off from the green light emitting laminate as prepared above. Then the resulting red coating formulation was coated with 50 micron layer thickness on the green light emitting polymer layer, then laminated with a barrier film of the same type as used for the green light emitting laminate whereby the side of the adhesive layer was adjacent the red emitting polymer layer. Afterwards the laminate structure was UV-cured for 60 s (UVAcube100 equipped with a mercury lamp and quartz filter, Hoenle, Germany). The initial performance of the as obtained film showed a red emission wavelength of 630 nm with a FWHM of 45 nm.

The thus obtained film was cut into rectangular pieces of 10 cm x 7 cm and had the following architecture: barrier film (25 micron) - green light emitting layer (50 micron) - red light emitting layer (50 micron) - barrier film (25 micron) with no edge sealing applied.

### Comparative example 2 (PLD edge - sealed film with red and green light emitting layer):

A color conversion film as in comp.ex.1 was used. However, this color conversion film does contain a sealing layer on the edge areas, applied by PLD (pulsed laser deposition) technique.

### Manufacturing, comp.ex.2:

Application of AlOx edge sealing by PLD: On each edge of the obtained film according to comp.ex.1, an AlOx sealing layer with 80 nm thickness was deposited with pulsed laser deposition (PLD). As this method is a directional deposition, the rectangular film had to be treated four times (repositioning after each PLD treatment) in order to apply an AlOx sealing layer on each of the four edges. After PLD treatment, the stack was disassembled to obtain inventive films of 10 cm x 7 cm comprising a dense AlOx sealing layer on each of the four edges.

### Test results, comp. ex. 1 and 2:

The stability of the un-sealed color conversion film according to comp. ex.1 and the PLD sealed color conversion film according to comp. ex.2 was tested for 500 hours with the rectangular 10cm x 7cm cut piece in a climate chamber with 65°C and 95% relative humidity.

The average edge ingress on all four edges was measured for the green emission and red emission separately. (red edge ingress means the distance from the film edge towards the film centre over which no or strongly reduced red light emission is present compared to the center of the film; green edge ingress means the distance from the film edge towards the film centre over which no or strongly reduced green light emission is present compared to the center of the film).

Furthermore, the number of edge ingress spikes (locally existing spots with higher edge ingress compared to the average edge ingress over all four edges) were determined by visual inspection of all four edges (edge ingress spikes can result from cracks or local barrier film delamination at the film edge).

Result after 500 h under 65°C/95% r.H for the initial film without inorganic edge sealing:
- Average green edge ingress over all four edges: 1.5 mm
- Average red edge ingress over all four edges: 1.0 mm
- Number of edge ingress spikes over all four edges: cannot be determined as average edge ingress is too large

Result after 500 h under 65°C/95% r.H for the film with PLD-deposited inorganic edge sealing:
- Average green edge ingress over all four edges: < 0.1 mm
- Average red edge ingress over all four edges: < 0.1 mm
- Number of edge ingress spikes over all four edges: 12

### Conclusion, comparative examples 1 and 2:

These results show that the initial film without inorganic edge sealing exhibits a large edge ingress for green and red because no edge sealing is present.

The results also show that a PLD-deposited inorganic sealing layer results in the prevention of average green and red edge ingress, but there is still 12 edge ingress spikes present which indicate the presence of cracks or defects in the edge. This shows the edges are not uniformly coated by the inorganic layer applied via PLD and thus allows oxygen and/or humidity to penetrate into the color conversion film at these defect sites.

### Example 1: (inventive)

A color conversion film, comprising a green light emitting polymer layer with perovskite crystals and a red light emitting polymer layer with core-shell quantum dots comprising Indium and whereby the color conversion film contains an ALD-deposited inorganic sealing layer on the edge areas, was prepared as follows:

### Manufacturing:

A pile/stack of 10 pieces of the color conversion films (initial films without the presence of an inorganic edge sealing) of comparative example 1 separated with 200 micron PDMS films was compressed with a clamp and placed in the reaction chamber of an ALD batch reactor. Then an AlOx inorganic sealing layer with a thickness of 20nm was deposited on the whole pile of color conversion films by the ALD process described in Nehm et al. (ACS Appl. Mater. Interfaces 2015, 7, 22121-22127). Like in Nehm et al. the ALD deposition process was conducted at 80°C. The first reactant gas was electronic grade trimethylaluminium and the second reactant gas was deionized water.

As a result all four edge areas were coated with the 20nm AlOx sealing layer while the major surfaces of each color conversion film (except for the color conversion film on the very top of the pile of color conversion films) did not contain an AlOx sealing layer.

### Test results, Example 1:

The films were subject to the same degradation test as comp.ex.1 and 2: Result obtained after 500 h under 65°C/95% r.H for the films with ALD-deposited AlOx edge sealing:
- Average green edge ingress over all four edges: 0 mm
- Average red edge ingress over all four edges: 0 mm
- Number of edge ingress spikes over all four edges: 0

### Conclusion, ex. 1:

This result shows that the ALD-deposited AlOx sealing layer effectively prevented oxygen and/or humidity to diffuse into the color conversion films via the edge areas. It indicates that all cracks or other defects are uniformly coated with the AlOx sealing layer thus avoiding the formation of edge ingress spikes at these defect sites. This further shows that ALD deposited inorganic sealing layers are advantageous compared to inorganic sealing layers deposited with other directional vapour deposition techniques such as PLD.

### Example 2 (inventive, ALD deposition on edges and major surfaces:

A color conversion film, comprising a green light emitting polymer layer with perovskite crystals and a red light emitting polymer layer with core-shell quantum dots comprising Indium and whereby the color conversion film contains an ALD-deposited inorganic sealing layer on the edge areas and on both major surfaces, was prepared as follows:

### Manufacturing:

Step A: A color conversion film was prepared according to comparative example 1 where the two barrier films (comprising SiOx as barrier material) were replaced by two 100 micron PET films with adhesive layer. The thus obtained film was cut into rectangular pieces of 10 cm x 7 cm and had the following architecture: PET layer (100 micron) - green light emitting layer (50 micron) - red light emitting layer (50 micron) - PET film (100 micron), with no edge sealing applied.
   Then, a 20 nm thick AlOx sealing layer was deposited on a pile/stack of color conversion films according to the procedure in example 1. This resulted in an ALD-coated AlOx sealing on each of the four edges. (film 2.A)
Step B: Then the pile/stack of ALD treated color conversion films was again ALD treated with the same ALD processing conditions as in example 1 except the following changes:
   - The PDMS separating films were removed from the pile/stack.
   - The pile/stack of edge-sealed color conversion films was rotated in the ALD reaction chamber in order that one side of color conversion film edges are placed on the bottom of the reaction chamber thus the color conversion films being vertically arranged.
   - The color conversion films were separated from each other to obtain an air-gap of about 5 mm between each color conversion film thus letting ALD reactants to diffuse into the air-gaps and deposit the ALD layer on both major surface areas (ie. top and bottom film area) .

The resulting ALD treated color conversion films exhibited an AlOx sealing layer on all four edge areas and both the top and bottom film area. (film 2.B)

### Test results, example 2:

The films were subject to the same degradation test as above. Result after 500 h under 65°C/95% r.H for the films with ALD-deposited AlOx sealing layer on all edge areas and top and bottom film area:
- Average green edge ingress over all four edges: 0 mm
- Average red edge ingress over all four edges: 0 mm
- Number of edge ingress spikes over all four edges: 0

The following color conversion films of this experiment were additionally compared with regards to film luminance drop after 500h under 65°C/95% r.H. by measuring the luminance value with a Konica Minolta spectrometer (CS-2000) on a blue backlight before and after stability testing:
- Color conversion film with an AlOx sealing layer on all edge areas but no AlOx layer on the top and bottom film area → Luminance drop: - 65%
- Color conversion film with an AlOx sealing layer on all edge areas and the top and bottom film area → Luminance drop: - 8%

### Conclusion, example 2:

These results show that the ALD-deposited AlOx sealing layer effectively prevented oxygen and/or humidity to diffuse into the color conversion films via the edge areas. It indicates that all cracks or other defects are uniformly coated with the AlOx sealing layer thus avoiding the formation of edge ingress spikes at these defect sites. Furthermore these results show that the ALD batch process procedure used in this experiment allows not only to effectively seal film edges but also top and bottom film areas. This avoids the use of expensive barrier films (containing inorganic layers) in the manufacturing of native color conversion films.

### Comparative Example 3: (commercial product)

### Maufacturing:

A color conversion film comprising red and green Indium phosphide quantum dots was obtained by disassembling a commercial Samsung TV (Model: QN85A from 2021). The red and green quantum dots in this color conversion film are present in one light emitting polymer layer which is sandwiched between two inorganic barrier films (Architecture of the barrier film: PET substrate / inorganic layer / adhesive layer).

The stability testing for the films with 10cm x 7cm was done according to the procedure in the previous examples. Result after 500 h under 65°C/95% r.H for the initial film without inorganic edge sealing:
- Average green edge ingress over all four edges: 1.0 mm
- Average red edge ingress over all four edges: 1.0 mm
- Number of edge ingress spikes over all four edges: cannot be determined as average edge ingress is too large

### Example 3: (improved commercial product by ALD deposition on edges)

### Manufacturing:

A color conversion film comprising red and green Indium phosphide quantum dots was obtained by disassembling a commercial Samsung TV (Model: QN85A from 2021). The red and green quantum dots in this film are present in one light emitting polymer layer which is sandwiched between two inorganic barrier films (Architecture of the barrier film: PET substrate / inorganic layer / adhesive layer).

A pile/stack of 10 pieces of such films with 10cm x 7cm dimension were ALD processed with the same procedure as in example 1.

### Test results, example 3:

Result after 500 h under 65°C/95% r.H for the films with ALD-deposited AlOx edge sealing (inventive, ex. 3.2):
- Average green edge ingress over all four edges: 0 mm
- Average red edge ingress over all four edges: 0 mm
- Number of edge ingress spikes over all four edges: 0

### Conclusion, example 3:

This result shows that the ALD-deposited AlOx sealing layer effectively prevented oxygen and/or humidity to diffuse into the color conversion films via the edge areas. It indicates that all cracks or other defects are uniformly coated with the AlOx sealing layer thus avoiding the formation of edge ingress spikes at these defect sites.

It further indicates that commercially available films, considered state of the art, are significantly improved by the inventive method.

### Summary on examples:

The examples provided above may be summarized as follows:

| | |
|---|---|
| comp. ex.1 | no edge sealing, |
| | separate layers red and green |
| | conventional barrier layer |
| comp. ex.2 | PLD - edge sealing, |
| | separate layers red and green |
| | conventional barrier layer |
| comp. ex.3 | no edge sealing, |
| | combined red + green layer |
| | conventional barrier layer |
| | commercial product |
| ex. 1 | ALD - edge sealing, |
| | separate layers red and green |
| | conventional barrier layer |
| ex. 2 | ALD - edge sealing, |
| | separate layers red and green |
| | ALD - barrier layer |
| ex. 3 | ALD - edge sealing, |
| | combined red and green layer |
| | conventional barrier layer |
| | improved commercial product |

Characteristics of sealing layer (030) on the edges are summarized as follows:

| Example | thickness* | standard deviation of thickness* | chracteristics** |
|---|---|---|---|
| comp. ex.1 | - | - | no sealing |
| comp. ex.2 | ~ 80 nm | > 10% | incomplete, defective |
| comp. ex.3 | - | - | no sealing |
| ex. 1 | Ca. 20 nm | < 3% | complete , defect free |
| ex. 2 | Ca. 20 nm | < 3% | complete, defect free |
| ex. 3 | Ca. 20 mm | < 3% | complete, defect free |

| | | | |
|---|---|---|---|
| * nominal thicknesses as expected by the used deposition processes ** determined by light microscopy and confirmed by edge ingress / absence of edge ingress. | | | |

Regarding edge ingress, the results obtained after 500 h under 65°C/95% r.H are as follows:

| Example | green edge ingress | red edge ingress | ingress spikes |
|---|---|---|---|
| comp. ex.1 | 1.5 mm | 1.0 | ** |
| comp. ex.2 | < 0.1 mm | < 0.1 mm | 12 |
| comp. ex.3 | 1.0 mm | 1.0 mm | ** |
| ex. 1 | 0 mm | 0 mm | 0 |
| ex. 2 | 0 mm | 0 mm | 0 |
| ex. 3 | 0 mm | 0 mm | 0 |

| | | | |
|---|---|---|---|
| **cannot be determined as average edge ingress is too large | | | |

Thus, ALD edge-coating resolves the issue of edge ingress and even improves commercial products significantly.

Regarding performance, the results obtained after 500 h under 65°C/95% r.H are as follows:

| Example | description | Luminescence drop |
|---|---|---|
| example 2 film 2.A | no surface coating top / bottom | -65% |
| example 2 film 2.B | ALD surface coating top/ bottom | - 8% |

Thus, ALD surface-coating resolves the issue of luminescence drop and is thus suited to replace commercial barrier films.

## Claims

1. A sealed color conversion film (010) comprising a native color conversion film (010') and one or more sealing layers (30),
the native color conversion film (010')
• having two major surfaces (021, 022) and at least one edge (011, 012, 013, 014),
• comprising a color conversion material (80, 100, 200) which upon excitation with blue light emits light in the visible range; and
the sealing layer (030)
• is located on all edges of the native color conversion film, thereby providing a complete and defect-free covering of the edges, and
• has a thickness of 1 - 500 nm, preferably 3 - 200 nm, most preferably 10 - 100 nm, and
• has a thickness standard deviation including all edges of less than 10%, preferably less than 3%, most preferably less than 1%;
**characterized in that** the sealing layer is an atomic layer deposited inorganic layer.

2. The color conversion film of claim 1 which is rectangular shaped, having a top and bottom surface (021, 022) and four edges (011, 012, 013, 014) and complying with one or more of the following characteristics:
• an aspect ratio 4:3, 3:2, 16:9 or 3 : 1;
• a diagonal of 5 cm to 250 cm;
• a thickness of 10 - 500 micrometers.

3. The color conversion film according to any one of the previous claims comprising either
• a light emitting polymer layer comprising a green color conversion material (100) and optionally a further light emitting polymer layer comprising red color conversion material (200); or
• a light emitting polymer layer comprising a green color conversion material (100) and red color conversion material (200);
whereby the green color conversion material upon excitation by blue light emits green light, and
whereby the red color conversion material upon excitation by blue light emits red light.

4. The color conversion film according to claim 3, whereby
• the green color conversion material (100) is selected from the group of perovskite crystals; and
• the red color conversion material (200) is selected from the group of core-shell quantum dots comprising Indium.

5. The color conversion film according to any one of the previous claims whereby the inorganic sealing layer 030 comprises or consists of one or more metal oxides; preferably whereby the inorganic sealing layer 030 comprises or consists of the following layer sequence: AlOₓ / MOₓ with M = Si, Ti, Zr, Hf.

6. The color conversion film to any one of the previous claims wherein
• the color conversion film 010 comprises an inorganic sealing 030 covering all edges ("edge sealing") but no, or essentially no, inorganic coating on its major surfaces 030'; or
• the color conversion film 010 has in addition to the inorganic sealing 030 covering all edges ("edge sealing") an inorganic sealing 030' covering both major surfaces ("surface sealing") and wherein thickness of the surface sealing 030' is lower than the average thickness of the edge sealing 030 and wherein the inorganic material of the surface sealing 030' is the same or different to the inorganic material of the edge sealing 030; or
• the color conversion film 010 has in addition to the inorganic sealing 030 covering all edges ("edge sealing") an inorganic sealing 030' covering both major surfaces ("surface sealing") and wherein the surface sealing 030'and the edge sealing 030 have essentially the same thickness and preferably wherein the inorganic material of the surface sealing 030' is the same as the inorganic material of the edge sealing 030.

7. The color conversion film according to claim 6 whereby the inorganic surface sealing layer 030' comprises or consists of one or more metal oxides; preferably whereby the inorganic sealing layer 030' comprises or consists of the following layer sequence: AlOₓ / MOₓ with M = Si, Zr, Ti, Hf.

8. The color conversion film according to any one of the previous claims comprising either of the following layer sequences:
• green light emitting polymer layer comprising perovskite crystals / red light emitting polymer layer comprising core-shell quantum dots comprising Indium; or
• Intermediate layer comprising acrylate polymer or methacrylate polymer / green light emitting polymer layer comprising perovskite crystals / red light emitting polymer layer comprising core-shell quantum dots comprising Indium.

9. The color conversion film according to any one of the previous claims comprising one or more additional layers 070 on the top and/or bottom which do not contain an inorganic sealing layer 030 on the edge areas.

10. A method for manufacturing a color conversion film according to any one of the previous claims comprising the steps of:
(a) providing a multitude of native color conversion films (010') and assembling them to a stack (020);
(b) subjecting the stack of step (a) to a first atomic layer deposition process to thereby obtain a stack of sealed color conversion films (010);
(c) optionally repeating steps (a) and (b) to thereby obtain a multi-sealed color conversion film;
(d) optionally subjecting the sealed or multi-sealed color conversion film to finishing steps.

11. The method of claim 10, wherein in step (a) the stack (020)
contains native color conversion films (010') which are in direct contact with each other via their major surfaces; or
contains native color conversion films (010') which are separated by an auxiliary separating film;
to thereby obtain a color conversion film with edge-sealing.

12. The method of claim 10, wherein in step (a) the stack (020)
contains a multitude of native color conversion films (010') which are each separated from another by an air gap;
to thereby obtain a color conversion film with edge-sealing and surface sealing and where edge and surface sealing contain the same material and are of the same, or essentially the same, thickness.

13. The method of claim 10, wherein in step (c)
the initially obtained stack is re-assembled into a modified stack where the initially obtained color conversion films (010) are each separated from another by an air gap, followed by a second ALD process;
to thereby obtain a color conversion film with edge-sealing and surface sealing and whereby edge and surface sealing layers contain the same or different inorganic material and whereby the thickness of the surface sealing layer is lower than the edge sealing layer.

14. The method according to any of claims 10 - 13, whereby the ALD process complies with one or more of the following parameters:
• the ALD Process is conducted at 50 - 170°C;
• the ALD process is conducted at below 10 mbar;
• a first reactant for the ALD process is selected from the group consisting of metal chlorides, metal alkoxides, and alkylated metal;
• a second reactant for the ALD process is selected from the group consisting of H₂O and ozone.

15. A color conversion film obtained by the method of claims 10 - 14, preferably a color conversion film according to any of claims 1 - 9.

16. A display backlight component comprising a color conversion film according to claims 1 - 9 or 15.

17. A light emitting device, preferably a Liquid Crystal Display, comprising a color conversion film according to claims 1 - 9 or 15.

## Patentansprüche

1. Eine versiegelte Farbumwandlungsfolie (010), die eine native Farbumwandlungsfolie (010') und eine oder mehrere Versiegelungsschichten (30) umfasst,
wobei die native Farbumwandlungsfolie (010')
• zwei Hauptflächen (021, 022) und mindestens eine Kante (011, 012, 013, 014) hat,
• ein Farbumwandlungsmaterial (80, 100, 200) hat, das, wenn es durch blaues Licht angeregt wird, Licht im sichtbaren Bereich emittiert; und
wobei die Versiegelungsschicht (030)
• sich an allen Kanten der nativen Farbumwandlungsfolie befindet, wodurch eine vollständige und fehlerfreie Abdeckung der Kanten gewährleistet wird, und
• eine Dicke von 1 bis 500 nm hat, vorzugsweise von 3 bis 200 nm, am meisten bevorzugt von 10 bis 100 nm, und
• eine Standardabweichung der Dicke hat, die alle Kanten einschliesst, von weniger als 10%, vorzugsweise weniger als 3%, am meisten bevorzugt weniger als 1%;
**dadurch gekennzeichnet, dass** die Versiegelungsschicht eine anorganische Schicht ist, die durch eine Atomschicht abgeschieden wird.

2. Die Farbumwandlungsfolie nach Anspruch 1, die eine rechteckige Form hat, eine obere und eine untere Fläche (021, 022) und vier Kanten (011, 012, 013, 014) aufweist und eines oder mehrere der folgenden Merkmale erfüllt:
• ein Bildformat von 4:3, 3:2, 16:9 oder 3:1;
• eine Diagonale von 5 cm bis 250 cm;
• eine Dicke von 10 bis 500 Mikrometern.

3. Die Farbumwandlungsfolie nach einem der vorangehenden Ansprüche, umfassend entweder
• eine lichtemittierende Polymerschicht, die ein grünes Farbumwandlungsmaterial (100) umfasst, und optional eine weitere lichtemittierende Polymerschicht, die ein rotes Farbumwandlungsmaterial (200) umfasst; oder
• eine lichtemittierende Polymerschicht, die ein grünes Farbumwandlungsmaterial (100) und ein rotes Farbumwandlungsmaterial (200) umfasst;
wobei das grüne Farbumwandlungsmaterial grünes Licht ausstrahlt, wenn es durch blaues Licht angeregt wird, und
das rote Farbumwandlungsmaterial rotes Licht ausstrahlt, wenn es durch blaues Licht angeregt wird.

4. Die Farbumwandlungsfolie nach Anspruch 3, wobei
• das grüne Farbumwandlungsmaterial (100) aus der Gruppe der Perowskitkristalle ausgewählt ist; und
• das rote Farbumwandlungsmaterial (200) aus der Gruppe der Kern-Schale-Quantenpunkte ausgewählt ist, die Indium umfassen.

5. Die Farbumwandlungsfolie nach einem der vorangehenden Ansprüche, wobei die anorganische Versiegelungsschicht 030 ein oder mehrere Metalloxide umfasst oder daraus besteht; vorzugsweise, wobei die anorganische Versiegelungsschicht 030 die folgende Schichtfolge umfasst oder daraus besteht: AlOₓ / MOₓ mit M = Si, Ti, Zr, Hf.

6. Die Farbumwandlungsfolie nach einem der vorangehenden Ansprüche, wobei
• Die Farbumwandlungsfolie 010 umfasst eine anorganische Versiegelung 030 umfasst, die alle Kanten bedeckt ("Kantenversiegelung"), aber keine oder im Wesentlichen keine anorganische Beschichtung auf ihren Hauptflächen 030'; oder
• Die Farbumwandlungsfolie 010 weist neben der anorganischen Versiegelung 030, die alle Kanten bedeckt ("Kantenversiegelung"), eine anorganische Versiegelung 030' auf, die beide Hauptflächen bedeckt ("Oberflächenversiegelung"), und wobei die Dicke der Oberflächenversiegelung 030' geringer ist als die durchschnittliche Dicke der Kantenversiegelung 030 und wobei das anorganische Material der Oberflächenversiegelung 030' gleich oder verschieden ist von dem anorganischen Material der Kantenversiegelung 030; oder
• die Farbumwandlungsfolie 010 neben der anorganischen Versiegelung 030, die alle Kanten bedeckt ("Kantenversiegelung"), eine anorganische Versiegelung 030' aufweist, die beide Hauptflächen bedeckt ("Oberflächenversiegelung") und wobei die Oberflächenversiegelung 030' und die Kantenversiegelung 030 im Wesentlichen die gleiche Dicke haben und wobei vorzugsweise das anorganische Material der Oberflächenversiegelung 030' das gleiche ist wie das anorganische Material der Kantenversiegelung 030.

7. Die Farbumwandlungsfolie nach Anspruch 6, wobei die anorganische Oberflächenversiegelungsschicht 030' ein oder mehrere Metalloxide umfasst oder daraus besteht; vorzugsweise, wobei die anorganische Versiegelungsschicht 030' die folgende Schichtfolge umfasst oder daraus besteht: AlOₓ / MOₓ mit M = Si, Zr, Ti, Hf.

8. Die Farbumwandlungsfolie nach einem der vorangehenden Ansprüche, die eine oder mehrere der folgenden Schichtfolgen enthält:
• Grüne lichtemittierende Polymerschicht, die Perowskitkristalle umfasst / rote lichtemittierende Polymerschicht, die Kern-Schale-Quantenpunkte umfasst, die Indium umfassen; oder
• Zwischenschicht, die ein Acrylat- oder Methacrylatpolymer umfasst / Grünes Licht emittierende Polymerschicht, die Perowskitkristalle umfasst / Rotes Licht emittierende Polymerschicht, die Kern-Schale-Quantenpunkte umfasst, die Indium umfassen.

9. Die Farbumwandlungsfolie nach einem der vorangehenden Ansprüche, die eine oder mehrere zusätzliche Schichten 070 auf der Ober- und/oder Unterseite umfasst, die keine anorganische Versiegelungsschicht 030 an den Kantenbereichen enthalten.

10. Ein Verfahren zur Herstellung einer Farbumwandlungsfolie nach einem der vorangehenden Ansprüche, das die folgenden Schritte umfasst:
(a) Bereitstellen einer Vielzahl von nativen Farbumwandlungsfolien (010') und Zusammenfügen dieser zu einem Stapel (020);
(b) Unterziehen des Stapels aus Schritt (a) einem ersten Atomlagenabscheidungsprozess, um einen Stapel versiegelter Farbumwandlungsblätter (010) zu erhalten;
(c) optional Wiederholen der Schritte (a) und (b), um eine mehrfach versiegelte Farbumwandlungsfolie zu erhalten;
(d) optional Unterziehen der versiegelten oder mehrfach versiegelten Farbumwandlungsfolie zu Nachbearbeitungsschritten.

11. Das Verfahren nach Anspruch 10, wobei in Schritt (a) der Stapel (020)
Native Farbumwandlungsfolien (010') enthält, die über ihre Hauptflächen in direktem Kontakt miteinander stehen; oder
native Farbumwandlungsfolien (010') enthält, die durch eine Hilfstrennfolie getrennt sind;
um eine Farbumwandlungsfolie mit Kantenversiegelung zu erhalten.

12. Das Verfahren nach Anspruch 10, wobei in Schritt (a) der Stapel (020)
eine Vielzahl von nativen Farbumwandlungsfolien (010') enthält, die durch einen Luftraum voneinander getrennt sind;
um eine Farbumwandlungsfolie mit Kantenversiegelung und Oberflächenversiegelung zu erhalten, wobei die Kantenversiegelung und die Oberflächenversiegelung das gleiche Material enthalten und die gleiche Dicke haben oder im Wesentlichen die gleiche Dicke haben.

13. Das Verfahren nach Anspruch 10, wobei in Schritt (c)
der ursprünglich erhaltene Stapel wieder zu einem modifizierten Stapel zusammengesetzt wird, in dem die ursprünglich erhaltenen Farbumwandlungsfolien (010) durch einen Luftspalt voneinander getrennt werden, gefolgt von einem zweiten ALD -Prozess ;
um eine Farbumwandlungsfolie mit Kantenversiegelung und Oberflächenversiegelung zu erhalten, wobei die Kante- und Oberflächenversiegelungsschichten das gleiche oder ein unterschiedliches anorganisches Material enthalten und die Dicke der Oberflächenversiegelungsschicht geringer ist als die der Kantenversiegelungsschicht.

14. Das Verfahren nach einem der Ansprüche 10 bis 13, wobei der ALD-Prozess einem oder mehreren der folgenden Parameter entspricht:
• der ALD-Prozess findet bei einer Temperatur zwischen 50 und 170°C statt;
• der ALD-Prozess wird bei weniger als 10 mbar durchgeführt;
• ein erstes Reagenz für den ALD-Prozess ist aus der Gruppe ausgewählt, die aus Metallchloriden, Metallalkoxiden und alkylierten Metallen besteht;
• ein zweites Reagenz für den ALD-Prozess wird aus der Gruppe ausgewählt, die aus H₂O und Ozon besteht.

15. Eine Farbumwandlungsfolie, die durch das Verfahren nach den Ansprüchen 10 bis 14 erhalten wurde, vorzugsweise eine Farbumwandlungsfolie nach einem der Ansprüche 1 bis 9.

16. Eine Komponente für die Hintergrundbeleuchtung eines Bildschirms, die eine Farbumwandlungsfolie nach den Ansprüchen 1 bis 9 oder 15 umfasst.

17. Eine lichtemittierende Vorrichtung, vorzugsweise ein Flüssigkristallbildschirm, umfassend eine Farbumwandlungsfolie nach den Ansprüchen 1 bis 9 oder 15.

## Revendications

1. Une feuille de conversion des couleurs scellée (010), comprenant une feuille de conversion des couleurs native (010') et une ou plusieurs couches de scellement (30),
la feuille de conversion des couleurs natives (010')
• ayant deux surfaces principales (021, 022) et au moins un bord (011, 012, 013, 014),
• comprenant un matériau de conversion des couleurs (80, 100, 200) qui, lorsqu'il est excité par une lumière bleue, émet une lumière dans le domaine visible ; et
la couche de scellement (030)
• étant située sur tous les bords de la feuille de conversion des couleurs natives, assurant ainsi une couverture complète et sans défaut des bords, et
• ayant une épaisseur de 1 à 500 nm, de préférence de 3 à 200 nm, le plus préféré de 10 à 100 nm, et
• ayant un écart-type d'épaisseur incluant tous les bords inférieurs à 10%, de préférence inférieurs à 3%, le plus préféré inférieurs à 1% ;
**caractérisée en ce que** la couche de scellement est une couche inorganique déposée par couche atomique.

2. La feuille de conversion des couleurs selon la revendication 1, ayant une forme rectangulaire, ayant une surface supérieure et inférieure (021, 022) et quatre bords (011, 012, 013, 014) et répondant à une ou plusieurs des caractéristiques suivantes :
• un format d'image 4:3, 3:2, 16:9 ou 3:1 ;
• une diagonale de 5 cm à 250 cm ;
• une épaisseur de 10 à 500 micromètres.

3. La feuille de conversion des couleurs selon l'une des revendications précédentes, comprenant soit
• une couche de polymère émettant de la lumière comprenant un matériau de conversion de la couleur verte (100) et optionnellement une autre couche de polymère émettant de la lumière comprenant un matériau de conversion de la couleur rouge (200) ; ou
• une couche de polymère émettant de la lumière comprenant un matériau de conversion de la couleur verte (100) et un matériau de conversion de la couleur rouge (200) ;
le matériau de conversion de la couleur verte émettant de la lumière verte lorsqu'il est excité par la lumière bleue, et
le matériau de conversion de la couleur rouge émettant de la lumière rouge lorsqu'il est excité par la lumière bleue.

4. La feuille de conversion des couleurs selon la revendication 3, dans laquelle
• le matériau de conversion de la couleur verte (100) est choisi dans le groupe des cristaux de pérovskite ; et
• le matériau de conversion de la couleur rouge (200) est choisi dans le groupe des points quantiques noyau-coquille comprenant de l'indium.

5. La feuille de conversion des couleurs selon l'une des revendications précédentes, dans laquelle la couche de scellement inorganique 030 comprend ou consiste en un ou plusieurs oxydes métalliques ; de préférence, dans laquelle la couche de scellement inorganique 030 comprend ou consiste en la séquence de couches suivante : AlOₓ / MOₓ avec M = Si, Ti, Zr, Hf.

6. La feuille de conversion des couleurs selon l'une des revendications précédentes, dans laquelle
• La feuille de conversion des couleurs 010 comprend un scellement inorganique 030 couvrant tous les bords ("scellement des bords"), mais pas ou pratiquement pas de revêtement inorganique sur ses surfaces principales 030' ; ou
• La feuille de conversion des couleurs 010 comporte, outre le scellement inorganique 030 couvrant tous les bords ("scellement des bords"), un scellement inorganique 030' couvrant les deux surfaces principales ("scellement de la surface") et dans laquelle l'épaisseur du scellement de la surface 030' est inférieure à l'épaisseur moyenne du scellement des bords 030 et dans laquelle le matériau inorganique du scellement de la surface 030' est identique ou différent du matériau inorganique du scellement des bords 030 ; ou
• la feuille de conversion des couleurs 010 comporte, outre le scellement inorganique 030 couvrant tous les bords ("scellement des bords"), un scellement inorganique 030' couvrant les deux surfaces principales ("scellement de la surface") et dans laquelle le scellement de la surface 030' et le scellement des bords 030 ont essentiellement la même épaisseur et, de préférence, dans laquelle le matériau inorganique du scellement de la surface 030' est le même que le matériau inorganique du scellement des bords 030.

7. La feuille de conversion des couleurs selon la revendication 6, dans laquelle la couche inorganique de scellement de surface 030' comprend ou consiste en un ou plusieurs oxydes métalliques ; de préférence, dans laquelle la couche inorganique de scellement 030' comprend ou consiste en la séquence de couches suivante : AlOₓ / MOₓ avec M = Si, Zr, Ti, Hf.

8. La feuille de conversion des couleurs selon l'une des revendications précédentes, comprenant l'une ou l'autre des séquences de couches suivantes :
• Couche de polymère émettant de la lumière verte comprenant des cristaux de pérovskite / couche de polymère émettant de la lumière rouge comprenant des points quantiques noyau-coquille comprenant de l'indium ; ou
• Couche intermédiaire comprenant un polymère d'acrylate ou de méthacrylate / couche de polymère émettant de la lumière verte comprenant des cristaux de pérovskite / couche de polymère émettant de la lumière rouge comprenant des points quantiques noyau-coquille comprenant de l'indium.

9. La feuille de conversion des couleurs selon l'une des revendications précédentes, comprenant une ou plusieurs couches supplémentaires 070 sur le dessus et/ou le dessous qui ne contiennent pas une couche de scellement inorganique 030 sur les zones de bord.

10. Un procédé de fabrication d'une feuille de conversion des couleurs selon l'une des revendications précédentes, comprenant les étapes suivantes :
(a) fournir une multitude de feuilles de conversion des couleurs natives (010') et les assembler en une pile (020) ;
(b) soumettre la pile de l'étape (a) à un premier processus de dépôt de couche atomique afin d'obtenir une pile de feuilles de conversion de couleur scellés (010) ;
(c) optionnellement répéter les étapes (a) et (b) pour obtenir une feuille de conversion de couleur multi-scellé ;
(d) optionnellement, soumettre la feuille de conversion des couleurs scellé ou multi-scellé à des étapes de finition.

11. Le procédé selon la revendication 10, dans lequel, à l'étape (a), la pile (020)
contient des feuilles de conversion des couleurs natives (010') qui sont en contact direct les uns avec les autres par l'intermédiaire de leurs surfaces principales ; ou
contient des feuilles de conversion des couleurs natives (010') qui sont séparés par une feuille de séparation auxiliaire ;
afin d'obtenir une feuille de conversion des couleurs avec scellement des bords.

12. Le procédé selon la revendication 10, dans lequel, à l'étape (a), la pile (020)
contient une multitude de feuilles de conversion des couleurs natives (010') qui sont séparés les uns des autres par un espace d'air ;
afin d'obtenir une feuille de conversion des couleurs avec scellement des bords et scellement de la surface, où le scellement des bords et le scellement de la surface contiennent le même matériau et sont de la même épaisseur, ou essentiellement de la même épaisseur.

13. Le procédé selon la revendication 10, dans lequel à l'étape (c)
la pile initialement obtenue est réassemblée en une pile modifiée où les feuilles de conversion de couleur initialement obtenus (010) sont séparées les unes des autres par un espace d'air, suivi d'un second processus ALD ;
afin d'obtenir une feuille de conversion des couleurs avec scellement des bords et scellement de la surface, les couches de scellement des bords et de la surface contenant le même ou un différent matériau inorganique et l'épaisseur de la couche de scellement de la surface étant inférieure à celle de la couche de scellement des bords.

14. Le procédé selon l'une des revendications 10 à 13, le processus ALD étant conforme à un ou plusieurs des paramètres suivants :
• le processus ALD se déroule à une température comprise entre 50 et 170°C ;
• le processus ALD est mené à moins de 10 mbar ;
• un premier réactif pour le processus ALD est choisi dans le groupe constitué par les chlorures métalliques, les alcoxydes métalliques et les métaux alkylés ;
• un deuxième réactif pour le processus ALD est choisi dans le groupe constitué de H₂O et de l'ozone.

15. Une feuille de conversion des couleurs obtenue par le procédé selon les revendications 10 à 14, de préférence une feuille de conversion des couleurs selon l'une des revendications 1 à 9.

16. Un composant de rétroéclairage d'écran comprenant une feuille de conversion des couleurs selon les revendications 1 à 9 ou 15.

17. Un dispositif émetteur de lumière, de préférence un écran à cristaux liquides, comprenant une feuille de conversion des couleurs selon les revendications 1 à 9 ou 15.
